# EUROPEAN PATENT SPECIFICATION

(11) **EP 4 478 419 B1**
(45) Date of publication and mention of the grant of the patent: **08.04.2026**
(21) Application number: 24181676.8
(22) Date of filing: 12.06.2024
(51) Int. Cl.: H10D 30/01, H10D 30/47, H10D 62/17, H10D 64/00, H10D 62/85

(54) **GAN SEMICONDUCTOR POWER TRANSISTOR WITH SLANTED GATE FIELD PLATE AND CORRESSPONDING FABRICATION METHOD**
GAN-HALBLEITERLEISTUNGSTRANSISTOR MIT SCHRÄGER GATEFELDPLATTE UND ENTSPRECHENDES HERSTELLUNGSVERFAHREN
TRANSISTOR DE PUISSANCE À SEMI-CONDUCTEUR GAN AVEC PLAQUE DE CHAMP DE GRILLE INCLINÉE ET PROCÉDÉ DE FABRICATION CORRESPONDANT

(30) Priority: 13.06.2023 US 202318209128
(43) Date of publication of application: 18.12.2024
(73) Proprietor: Infineon Technologies Canada Inc., Kanata, Ontario K2V 1C8 (CA)
(72) Inventor: DIXIT, Abhinandan, Kanata, K2V 1C8 (CA); PRASAD, Jayasimha, Kanata, K2V 1C8 (CA); MACELWEE, Thomas, Kanata, K2V 1C8 (CA); UNNI, Vineet, Kanata, K2V 1C8 (CA)
(74) Representative: Kraus & Lederer PartGmbB

(56) References cited:
- US-A1- 2010 155 780
- US-A1- 2016 336 313
- COFFIE ROBERT: "Slant Field Plate Model for Field-Effect Transistors", IEEE TRANSACTIONS ON ELECTRON DEVICES, IEEE, USA, vol. 61, no. 8, 1 August 2014 (2014-08-01), pages 2867 - 2872, XP011554110, ISSN: 0018-9383, [retrieved on 20140721], DOI: 10.1109/TED.2014.2329475
- KOBAYASHI KENGO ET AL: "Current collapse suppression in AlGaN/GaN HEMTs by means of slant field plates fabricated by multi-layer SiCN", 4 July 2014 (2014-07-04), pages 63 - 69, XP093205685, Retrieved from the Internet <URL:https://www.sciencedirect.com/science/article/pii/S0038110114001555/pdfft?md5=b72d720fb5d1c6c8f0891172fb414f97&pid=1-s2.0-S0038110114001555-main.pdf> DOI: 10.1016/j.sse.2014.06.022

## Description

### TECHNICAL FIELD

This invention relates to Gallium Nitride (GaN) semiconductor power transistors, such as GaN HEMTs (High Electron Mobility Transistors), for high voltage and high current applications.

### BACKGROUND

In a field effect transistor, a field plate may be used to engineer or shape the electric field between electrodes, e.g. in the region around the gate and between the gate and the drain, of a power transistor to reduce the dynamic on-resistance and increase the device breakdown voltage.

The following references disclose examples of methods of forming stepped, tapered or slanted field plates for semiconductor power transistors:
US10,068,974B2 to Li et al., issued September 4, 2018, entitled "Field Plate Power Device and Method of Manufacturing the same".
US2008/0308813A1, to Suh et al., published December 18, 2008, entitled "High Breakdown Enhancement Mode Gallium Nitride based High Electron Mobility Transistors with Integrated Slant Field Plate";
US2021/0280678A1 to Patel, published September 9, 2020, entitled "Greyscale Lithography for Double Slanted Gate Connected Field Plate";
US8,530,978B1 to Chu et al., issued September 10, 2013, entitled "High Current High Voltage GaN Field Effect Transistors and Method of Fabricating the Same";
US10,068,974B2 issued September 4, 2018, entitled "Field Plate Power Device and Method of Manufacturing the same";
US9,929,243B1 to Corrion et al., issued March 27, 2018, entitled "Stepped Field Palate Wide Bandgap Field-Effect Transistor and Method";
US8,980,759B1 to Corrion et al., issued March 17, 2015, entitled "Method of Fabricating Slanted Field-Plate GaN Heterojunction Field-Effect Transistor";
US8,999,780B1 issued April 7, 2015, to Khalil et al., entitled "Non-uniform two-dimensional electron gas profile in III-Nitride HEMT devices";
US10,103,219B2 issued October 16, 2018, to Pei et al., entitled "Power Semiconductor Device and Method for Manufacturing the same".

Some of these device structures add significant process complexity and/or may not be compatible with existing fabrication processes offered by some semiconductor foundries.

In some device structures, gate metal is used to form a gate metal field plate (GFMP) For example, a stepped GMFP may be fabricated by gate metal deposition and etching, or by using a lift-off metallization process.

Lift-off refers to the process of patterning a masking material, e.g. photoresist, and depositing a thin film, e.g. gate metal, over the entire area, and then removing the masking material to leave behind the thin film only in the areas which were not masked. A disadvantage of a lift-off metallization process is the possibility of unwanted metal layers and haloes remaining on the surface of the wafer after lift-off. For high voltage applications, e.g. using GaN semiconductor HEMTs, the presence of unwanted metal extrusions can cause electric field crowding and potentially lead to dielectric failure.

US 2016/336313 A1 discloses a GaN semiconductor power transistor with a pGaN gate, a series of passivation layers as well as a stepped gate field plate connected to source. The stepped gate field plate and the p-GaN gate are configured in a Cascode configuration. The stepped field plate is furthermore, formed inside an insulating layer that has an increasing dielectric constant as distance increases away from the barrier layer.

US 2010/155780 A1 discloses another transistor structure in which the gate metal is used to form a gate metal field plate.

Coffie Robert: "Slant Field Plate Model for Field-Effect Transistors", IEEE Transactions on Electron Devices, vol. 61 no.8, pages 2867 to 2872 discusses slanted filed plates.

Kobayashi Kengo et al.: "Current collapse suppression in AlHaN/GaN HEMTs by means of slant field plates fabricated by multi-layer SiCN", XP093205685, DOI: 10.1016/j.sse.2014.06.022 discusses GaN/AlGaN HEMTs with slanted field plates.

There is a need for improved or alternative device structures and fabrication processes for power semiconductor transistors, e.g. GaN HEMTs, comprising gate metal field plates for high voltage applications.

### SUMMARY OF INVENTION

The present invention seeks to provide improved or alternative device structures and fabrication processes for GaN semiconductor power transistors, e.g. GaN HEMTs, comprising gate metal field plates, which overcome one or more of the above-mentioned issues.

According to some embodiments, a semiconductor device structure as defined in claim 1 and a method as defined in claim 6 are provided. The dependent claims define further embodiments.

Aspects of the invention provide a device structure comprising a GaN semiconductor power transistor, e.g. an enhancement-mode GaN HEMT, comprising a slanted gate field plate, and a method of fabrication.

One aspect provides a semiconductor device structure comprising an enhancement-mode GaN semiconductor power transistor comprising:
an epitaxial layer structure comprising a semiconductor substrate, a buffer layer, a GaN semiconductor heterostructure comprising a GaN channel layer and AlGaN barrier layer providing a 2DEG active region;
a p-GaN layer patterned to define a p-GaN gate region;
a first passivation layer;
contact openings through the first passivation layer for source contacts and drain contacts; ohmic contact metal within said contact openings which is patterned to form source contacts and drain contacts;
a second passivation layer;
a gate contact opening through the first and second passivation layers to the p-GaN gate region;
gate metal within the gate contact opening patterned to form a gate contact, the gate metal also forming a gate metal field plate in a region between the gate contact and the drain contact;
a third dielectric layer formed thereon having a graded composition wherein a bottom of the third dielectric layer has a denser composition than a top layer of the third dielectric layer;
openings etched through the third dielectric layer for a source contact, a drain contact and a gate contact, and another opening with slanted sidewalls etched through the third dielectric layer and etched through to the gate metal field plate, the graded composition of the third dielectric layer providing an etch rate differential that defines the slant angle of the slanted sidewalls,;
at least one layer of conductive metal filling each said openings to form the source contact, the drain contact, the gate contact and a slanted gate field plate,
the conductive metal filling the opening with the slanted sidewalls to form the slanted gate field plate in contact with the gate metal field plate.

The thickness of the third passivation layer and the slant angle of the slanted gate field plate are configured to shape an electric field under the slanted gate field plate between the gate contact and the drain contact.

Another aspect of the invention provides a method of fabricating a semiconductor device structure comprising an enhancement-mode GaN semiconductor power transistor comprising:
providing an epitaxial layer structure comprising a semiconductor substrate, a buffer layer, a GaN semiconductor heterostructure comprising a GaN channel layer and AlGaN barrier layer providing a 2DEG active region, and a blanket p-GaN layer;
etching the blanket p-GaN layer to define p-GaN gate regions;
providing a first passivation layer covering the p-GaN gate regions;
etching contact openings through the first passivation layer for a source contact and a drain contact;
depositing and patterning ohmic contact metal to form the source contact and the drain contact; providing a second passivation layer;
etching gate contact openings through the first and second passivation layers to the p-GaN gate regions;
depositing and patterning gate metal to form a gate contact and a gate metal field plate;
depositing a third dielectric layer overall, the third dielectric layer having a graded composition, a bottom of the third dielectric layer having a denser composition and slower etch rate than a top of the third dielectric layer;
performing a first etch process of the third dielectric layer to form contact openings for a source contact, a gate contact and a drain contact;
performing a second etch process of the third dielectric layer comprising a wet etch to form the slanted opening for the gate field plate that extends down to the gate metal field plate;
depositing at least one layer of conductive metal to fill the contact openings for the source contact, gate contact, and drain contact and to form a slanted gate field plate, the conductive metal filling the opening with the slanted sidewalls to form the slanted gate field plate (228) in contact with the gate metal field plate.

The thickness of the third passivation layer and the slant angle of the slanted gate field plate are configured to shape an electric field under the slanted gate field plate between the gate contact and the drain contact.

The step of depositing at least one layer of conductive metal may comprise depositing a single metal layer, or a plurality of metal layers.

Depositing and patterning the gate metal to form the gate contact and the gate metal field plate may comprise a lift-off metal process. Depositing and patterning the gate metal to the form gate contact and the gate metal field plate comprises deposition and etching of the gate metal.

An enhancement-mode GaN semiconductor power transistor structure with a slanted gate field plate and a method of fabrication is disclosed. In example embodiments, the resulting slanted field plate structure provides an electric field distribution which provides a lower and smoother Coss curve, thus improving a Figure of Merit (FOM) of the device.

### BRIEF DESCRIPTION OF THE DRAWINGS

**Fig. 1** shows a schematic cross-sectional view of a semiconductor device structure according to the invention, comprising an e-mode GaN HEMT comprising a gate metal contact and a gate metal field plate (GMFP) of a first example embodiment; and
**Figs. 2A to 2J** show schematic cross-sectional views to illustrate steps in a method of fabrication of a semiconductor device structure according to the invention, comprising an e-mode GaN HEMT comprising a gate metal contact and a gate metal field plate (GMFP) of the first example embodiment;
**Fig. 3** shows a schematic cross-sectional views to illustrate steps in a method of fabrication of a semiconductor device structure comprising an e-mode GaN HEMT comprising a gate metal contact and a gate metal field plate (GMFP) of a second example embodiment, not falling under the scope of the invention;
The foregoing and other features, aspects and advantages will be more apparent from the following detailed description, taken in conjunction with the accompanying drawings, of example embodiments, which description is by way of example only.

### DETAILED DESCRIPTION

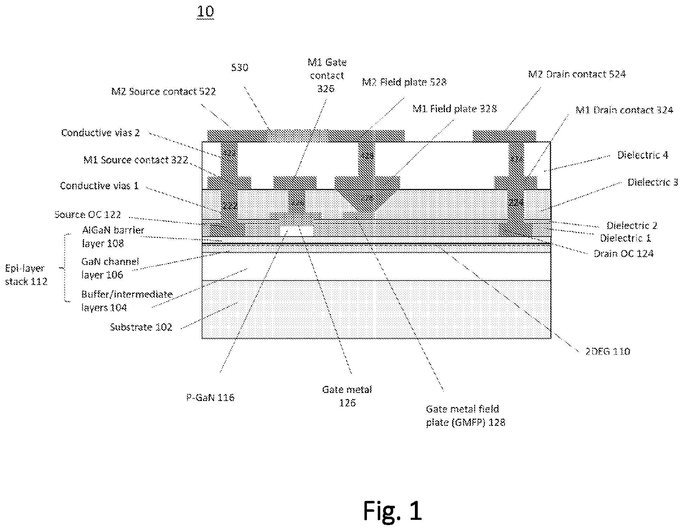

A schematic cross-sectional view of a device structure 10 comprising an enhancement mode (E-mode) GaN HEMT with a gate metal field plate of a first example embodiment is shown in Fig. 1. The GaN transistor is fabricated on a semiconductor substrate, e.g. a silicon substrate 102. The semiconductor layers comprise an epitaxial layer stack 112 comprising one or more buffer layers or intermediate layers 104, a GaN channel layer 106, and an overlying AlGaN barrier layer 108, which are formed epitaxially on the semiconductor substrate 102. For example, for a GaN-on-Silicon device structure, the substrate 102 may be p-doped silicon <111>. The latter may be referred to as the growth substrate. The GaN/AlGaN heterostructure layers 106/108 create a 2DEG (two-dimensional electron gas) active area 110 in device regions of the GaN-on-Si substrate. The stack of GaN epitaxial layers that is formed on the silicon substrate, i.e. intermediate layers 104, GaN layer 106, and AlGaN layer 108, and any intervening layers not actually illustrated, will be referred to below as the "epi-layer stack" or "epi-stack" 112. After formation of the epi-layer stack 112, source, drain and gate electrodes are formed. For example, a conductive metal layer, e.g. a layer of aluminum/titanium (Al/Ti), which forms an ohmic contact (OC) with the underlying GaN heterostructure layer, is deposited and patterned to define a source electrode 122 and a drain electrode 124. A gate electrode 126 is defined over the channel region between the source and drain electrodes, e.g. a gate electrode comprising a Schottky metal, such as palladium (Pd) or Gold (Au). The gate metal may comprise multiple layers, e.g. a thin layer of titanium (Ti), a thin layer of platinum, and a thicker layer of gold (Au). This device structure can be fabricated as a depletion mode (D-mode) device which is normally-on, or as an enhancement mode (E-mode) device, which is normally-off. For an E-mode HEMT, the gate structure includes a p-type semiconductor layer 116 provided in the region under the gate electrode, e.g. a p-type GaN layer or p-type AlGaN layer under the gate metal 126, as illustrated schematically in **Fig. 1****.** For a D-mode HEMT, the p-GaN layer is omitted, and the gate electrode is formed directly on the AlGaN barrier layer.

As illustrated schematically in **Fig. 1****,** the lateral GaN HEMT device structure also comprises a gate metal field plate (GMFP) 128. The GFMP comprises the same metal layer or layers as the gate metal., e.g. a multilayer metal comprising Ti/Pt/Au. The gate metal 126 and GFMP 128 may be formed by metal deposition and etching, or by a lift-off metallization process.

There is an overlying interconnect structure comprising one or more conductive metal layers, and dielectric layers. The interconnect structure may comprise a plurality of conductive metal layers, and intervening (inter-metal) dielectric layers, to provide source, drain and gate contacts. For example, a first layer of metal, which may be referred to a contact metal provides a source contact 222 to the source OC 122 and a drain contact 224 to the drain OC 124, and a gate contact 226 to the gate metal 126. Another layer of metal, labelled M1, provides a larger area source contact 322, a drain contact 324, and a gate contact 326. The contact metal and metal M1 may each comprise multiple conductive metal layers or be formed from a single conductive metal layer. The contact metal also defines a slanted gate field plate 228 that contacts the GMFP 128. Metal M1 defines a field plate contact area 328. The interconnect structure illustrated schematically in **Fig. 1** also includes a second metal layer, labelled M2, defining source contact area 522, drain contact area 524, and gate field plate contact area 528.

The GMFP 128 may be connected to source contact area 522 through metal M2 interconnect trace 530 to contact area 528, and through intervening metal layers including slanted field plate 228, as illustrated schematically in **Fig. 1****.**

For simplicity, in the GaN transistor structure illustrated in **Fig. 1****,** only a single source electrode, drain electrode and gate electrode is illustrated. Although only one transistor element is illustrated for device structure 10 in the simplified schematic cross-sectional view in **Fig. 1****,** it will be appreciated that large area, multi-island lateral GaN HEMT may be provided. In a multi-island lateral GaN HEMT, multiple transistor islands or cells are connected in parallel to form a large gate width transistor, with high current carrying capability. An inactive region, or isolation region may surround the 2DEG active device region. For example, the isolation region may be formed by ion implantation.

This device structure can be fabricated as a depletion mode (D-mode) device which is normally on, or as an enhancement mode (E-mode) device, which is normally off. For example, for a D-mode HEMT, the GaN heterostructure may comprise a layer of undoped GaN and a layer of undoped AlGaN, with the gate electrode formed directly on the AlGaN layer. For an enhancement mode (E-mode) HEMT, the GaN hetero-structure includes a p-type semiconductor layer 116 provided in the region under the gate electrode, e.g. p-type GaN layer or p-type AlGaN layer under the gate metal, as illustrated schematically in **Fig. 1****.**

The GFMP 128 is formed from the gate metal, which may comprise multiple metal layers, e.g. Ti/Pt/Au. To form the slanted gate field plate structure 228, the composition of Dielectric 3 has a graded composition, so that wet etching can form a tapered opening with a defined slant angle. For example, the third dielectric layer (Dielectric 3) has a graded composition, wherein a bottom of the third dielectric layer has a denser composition and slower etch rate than a top of the third dielectric layer, and the top of the third dielectric layer is less dense and has a higher etch rate.

For example, the dielectric passivation layers may comprise silicon dioxide, silicon nitride, silicon oxynitride and combinations thereof to provide the appropriate thicknesses and compositions. The structures shown in the drawings are simplified schematic representations and thicknesses and lateral dimensions are not drawn to scale..

For GaN HEMTs having a higher 2DEG density, insufficient thicknesses of dielectric under the GFMP can lead to degradation of the dielectric, which may create a leakage path. For example, if the thickness of Dielectric 1, e.g. SiN, under the GMFP is too thin, e.g. ≤100nm, this may be insufficiently thick for a device having a higher 2DEG density at the AlGaN/GaN interface. By choosing an appropriate slant angle, the dielectric thicknesses under a slanted gate field plate can be controlled, so that the electric field distribution can be optimized by suppressing the magnitude of the vertical electric field, which helps to reduce leakage, and improve the robustness and lifespan of the device.

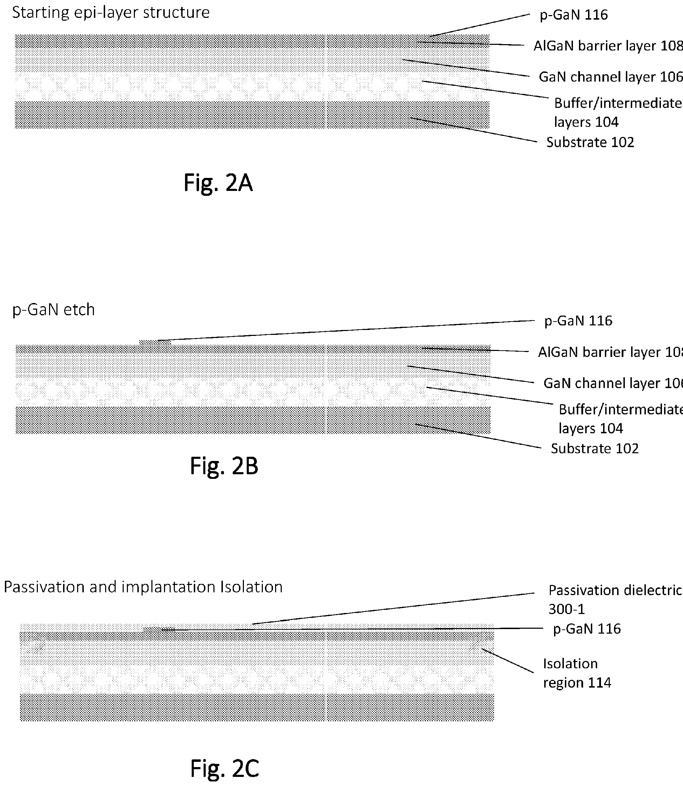

**Figs. 2A to 2J** shows schematic cross-sectional views to illustrate steps in an embodiment of a method of fabrication of a semiconductor device structure comprising an e-mode GaN HEMT comprising a gate metal contact and a gate metal field plate (GMFP) of the example embodiment shown in **Fig. 1****.**

As illustrated schematically in **Fig. 2A****,** in fabrication of GaN HEMTs for high voltage applications, the starting wafer may be an epitaxial wafer comprising a silicon substrate 102, and a GaN semiconductor epitaxial layer stack comprising one or more buffer/intermediate layers 104, a GaN channel layer 106, and an overlying AlGaN barrier layer 108. The GaN/AlGaN heterostructure layers create a 2DEG active region for device regions of the GaN-on-Si substrate. The epitaxial layer stack for enhancement mode GaN HEMTs comprising a p-GaN gate structure may include a blanket layer of p-GaN. A first step in the process is a p-GaN gate etch that defines the p-GaN gate area 116 for each transistor element, as illustrated schematically in **Fig. 2B****.** Careful control of device processing is required to maintain the micro-structural quality of the semiconductor layers of the starting wafer. For example, exposure of the semiconductor layers of AlGaN and p-GaN during device processing can create defect or trap states, which potentially lead to degradation of key static and dynamic electric parameters. As illustrated schematically in **Fig. 2C****,** it is therefore desirable to provide a first dielectric or passivation layer 300-1 over the p-GaN gate structures and over the AlGaN barrier layer prior to formation of ohmic contacts for the source and drain, and prior to providing the gate metal for the gate structure and gate metal field plate. After providing the passivation layer 300-1, an isolation region 114 may be provided around the active region, e.g. an ion implantation may be performed to form implantation isolation regions 114, surrounding the active region.

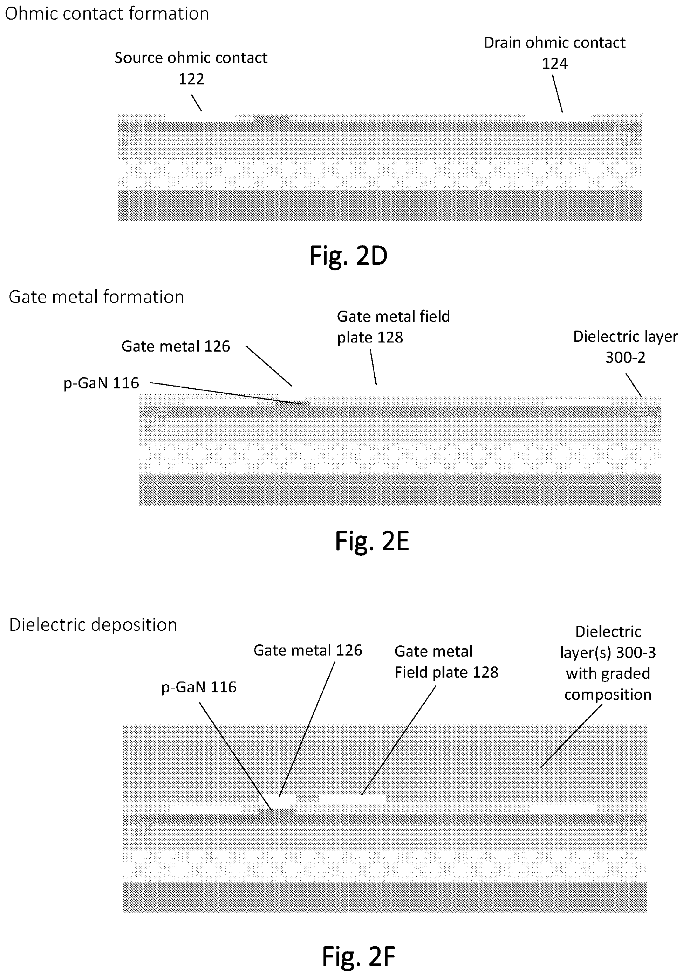

After forming the passivation layer 300-1, as illustrated schematically in **Fig. 2D****,** openings are made in the passivation layer 300-1 and a source ohmic contact 122 and a drain ohmic contact 124 are formed, by deposition and etching of the source and drain ohmic contact metal. After providing a second dielectric or passivation layer 300-2, a gate contact opening is made, and gate metal is provided by deposition and etch back, or using a lift-off process, as illustrated schematically in **Fig. 2E****.** The gate is patterned to form a gate contact 126 and a gate metal field plate 128

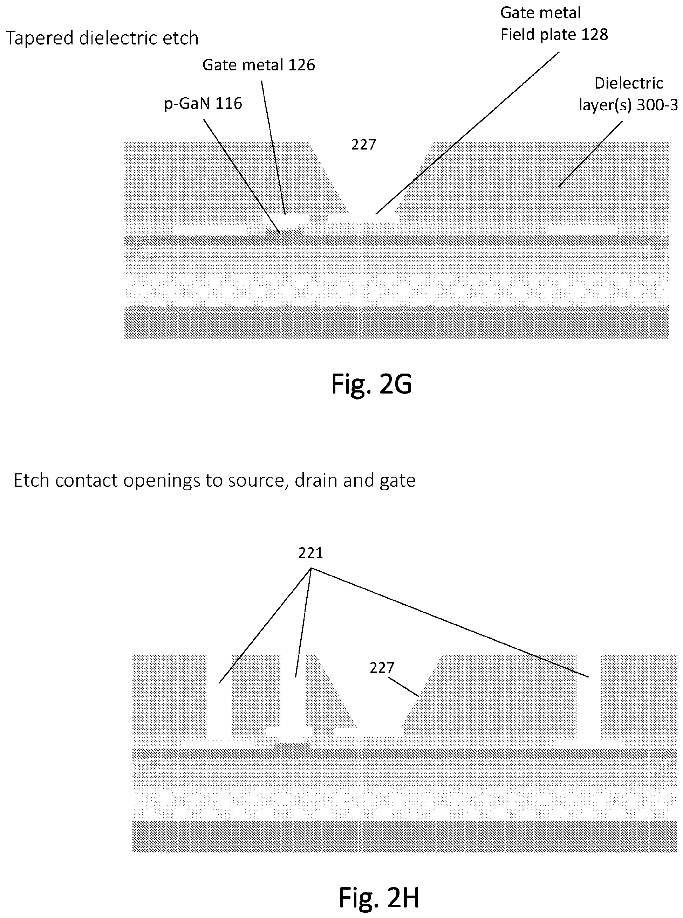

Then, as illustrated schematically in **Fig. 2F****,** a third dielectric layer 300-3 is then deposited to provide a required thickness of dielectric for forming an opening that will be used to define the structure of the slanted gate field plate 228. The third dielectric layer 300-3 is deposited with a graded composition, e.g. which is denser at the bottom and less dense at the top. The process then proceeds with a dielectric etch as illustrated schematically in **Fig. 2G** to form a tapered opening. The graded composition of the third dielectric layer 300-3 allows for wet etching of the third dielectric layer 300-3 to form a tapered opening with a pre-determined sidewall slant angle. The lower density composition at the top etches faster than the higher density composition at the bottom. The composition of the third dielectric layer is varied from the bottom to the top to control the etch rate and forms tapered sidewalls 227.

Contact openings 221 for the source, drain and gate are defined, e.g. by dry etching as illustrated schematically in **Fig 2H****.**

These etch steps provide openings for a source contact, a drain contact, a gate contact, and a slanted metal field plate.

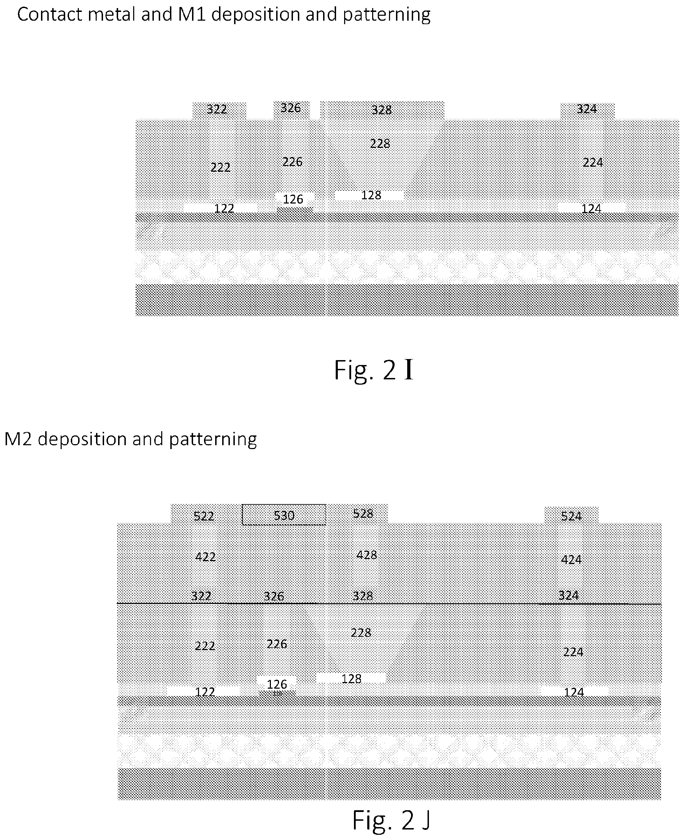

A contact metal deposition step may be used to form a source contact 222, a drain contact 224, a gate contact 226 and slanted gate field 228. A first metallization layer M1 is then deposited and patterned to provide contact areas for each, as illustrated schematically in **Fig. 2I****,** comprising a source contact area 322, a gate contact area 226, a gate metal field plate contact area 328 and a drain contact area 324.

If required, a second level interconnect may be provided, by depositing a fourth dielectric layer (intermetal dielectric) 300-4, etching contact openings, and forming a second metallization layer M2 to fill the contact openings and form M2 contact areas. As show schematically in **Fig. 2J****,** comprising source contact 422/522, drain contact 424/524, gate metal field plate contact 428/528. The gate metal field plate contact may be connected to source by region 530 of M2.

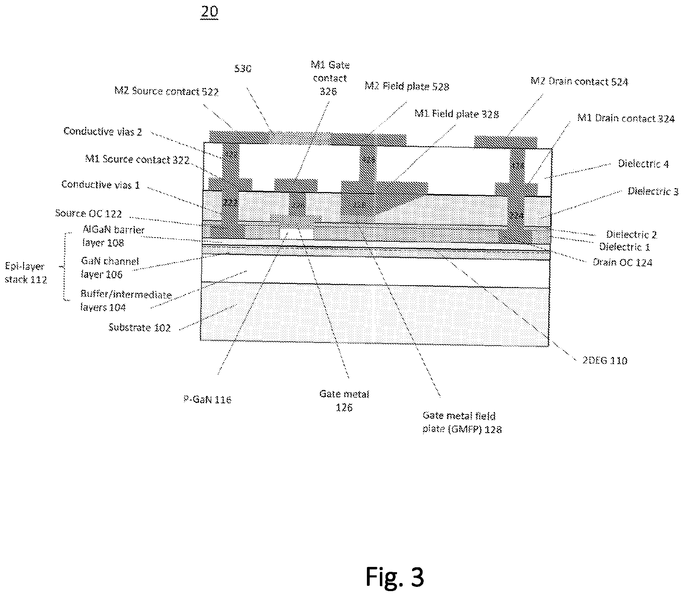

A schematic cross-sectional view of a device structure 20 comprising an enhancement mode (E-mode) GaN HEMT with a gate metal field plate of a second example embodiment not falling under the scope of the invention is shown in **Fig. 3****.** Corresponding parts are labelled with the same reference numerals as in Fig. 1. The device structure 20 shown schematically in **Fig. 3** differs from the device structure 10 shown schematically in **Fig. 1****,** in that the opening in dielectric 3 for the gate metal field plate 228-2 has a different lateral profile, to form a slanted field plate as illustrated schematically in **Fig. 3****,** which tapers towards the drain region.

In the example embodiments illustrated schematically in **Fig. 1** and **Fig. 3****,** the slant angle provides a smooth taper of the dielectric thickness under the field plate in the direction of the drain. In alternative embodiments, the gate metal field plate may have a more complex shape, which is controlled by grading of the composition of dielectric 3 with thickness, so that the etch rate of dielectric 3 is dependent on thickness, to control the slant angle of the opening in which the gate mental field plate is formed.

By choosing an appropriate slant angle, and dielectric thicknesses under a slanted field plate, the electric field distribution can be optimized by suppressing the magnitude of the vertical electric field, which helps to reduce leakage, and improve the robustness and lifespan of the device.

The above referenced related United States patent application no. 18/129,457, filed March 31, 2023, entitled "GaN Semiconductor Power Transistors With Stepped Metal Field Plates and Methods of Fabrication" discloses power semiconductor structures of example embodiments comprising stepped metal field plates. A GaN semiconductor power transistor of example embodiments comprising slanted gate metal field plates, fabricated as disclosed herein, may provide an improved E-field distribution, e.g. a lower and smoother Coss curve, to provide an improved Figure of Merit.

Although example embodiments have been described and illustrated in detail, it is to be clearly understood that the same is by way of illustration and example only and not to be taken by way of limitation, the scope of the present invention being limited only by the appended claims.

## Claims

1. A semiconductor device structure (10) comprising an enhancement-mode GaN semiconductor power transistor comprising:
an epitaxial layer structure (112) comprising a semiconductor substrate (102), a buffer layer (104), a GaN semiconductor heterostructure comprising a GaN channel layer (106) and AlGaN barrier layer (108) providing a 2DEG active region (110);
a p-GaN layer patterned to define a p-GaN gate region (116);
a first passivation layer (300-1);
contact openings through the first passivation layer for source contacts (122) and drain contacts (124);
ohmic contact metal within said contact openings which is patterned to form source contacts (122) and drain contacts (124);
a second passivation layer (300-2);
a gate contact opening through the first (300-1) and second (300-2) passivation layers to the p-GaN gate region (116);
gate metal within the gate contact opening patterned to form a gate contact (126), the gate metal also forming a gate metal field plate (128) in a region between the gate contact (126) and the drain contact (124);
a third dielectric layer (300-3) formed thereon having a graded composition wherein a bottom of the third dielectric layer has a denser composition than a top layer of the third dielectric layer;
openings (221) etched through the third dielectric layer for a source contact, a drain contact and a gate contact, and another opening with slanted sidewalls (227) etched through the third dielectric layer (300-3) and etched through to the gate metal field plate (128) at least one layer of conductive metal filling each said openings to form the source contact (222), the drain contact (224), the gate contact (226) and a slanted gate field plate (228), the conductive metal filling the opening with the slanted sidewalls (227) to form the slanted gate field plate (228) in contact with the gate metal field plate (128).

2. The semiconductor device structure (10) of claim 1, wherein the least one layer of conductive metal comprises a single metal layer.

3. The semiconductor device structure (10) of any one of claim 1, wherein the at least one layer of conductive metal comprises a plurality of metal layers.

4. The semiconductor device structure (10) of any one of claims 1 to 3, comprising an interconnect trace (530) connecting the source contact (222) and the slanted gate field plate (228).

5. The semiconductor device structure (10) of any one of claims 1 to 4, wherein the third dielectric layer(300-3) comprises a plurality of dielectric layers deposited sequentially to provide said graded composition.

6. A method of fabricating an enhancement-mode GaN semiconductor power transistor (10) comprising:
providing an epitaxial layer structure (112) comprising a semiconductor substrate (102), a buffer layer (104), a GaN semiconductor heterostructure comprising a GaN channel layer (106) and AlGaN barrier layer (108) providing a 2DEG active region (110), and a blanket p-GaN layer;
etching the blanket p-GaN layer to define p-GaN gate regions (116);
providing a first passivation layer (300-1) covering the p-GaN gate regions (106);
etching contact openings through the first passivation layer for a source contact (122) and a drain contact (124);
depositing and patterning ohmic contact metal to form the source contact (122) and drain contact (124);
providing a second passivation layer (300-2);
etching gate contact openings through the first (300-1) and second (300-2) passivation layers to the p-GaN gate regions (116);
depositing and patterning gate metal to form a gate contact (126) and a gate metal field plate (128);
depositing a third dielectric layer (300-3) overall, the third dielectric layer having a graded composition, a bottom of the third dielectric layer (300-3) having a denser composition and slower etch rate than a top of the third dielectric layer (300-3);
performing a first etch process of the third dielectric layer (300-3) to form contact openings (221) for a source contact, a gate contact and a drain contact;
performing a second etch process of the third dielectric layer (300-3) comprising a wet etch to form a slanted opening that extends down to the gate metal field plate (128);
depositing at least one layer of conductive metal to fill the contact openings for the source contact, gate contact, and drain contact and to form a slanted gate field plate (228) within the slanted opening such that the slanted gate field plate (228) makes contact with the gate metal field plate (128).

7. The method of claim 6, wherein the step of depositing at least one layer of conductive metal comprises one of depositing a single metal layer or depositing a plurality of metal layers.

8. The method of claim 6 or 7, wherein depositing and patterning gate metal to form the gate contact (126) and the gate metal field plate (128) comprises a lift-off metal process.

9. The method of any one of claims 6 to 8, wherein depositing and patterning gate metal to the form gate contact (126) and the gate metal field plate (128) comprises deposition and etching of the gate metal.

## Patentansprüche

1. Halbleiterbauelementstruktur (10), umfassend einen Anreicherungsmodus-GaN-Halbleiter-Leistungstransistor, umfassend:
eine Epitaxieschichtstruktur (112), umfassend ein Halbleitersubstrat (102), eine Pufferschicht (104), eine GaN-Halbleiter-Heterostruktur, umfassend eine GaN-Kanalschicht (106) und eine AlGaN-Sperrschicht (108), die einen aktiven 2DEG-Bereich (110) bereitstellt;
eine p-GaN-Schicht, die strukturiert ist, um einen p-GaN-Gate-Bereich (116) zu definieren;
eine erste Passivierungsschicht (300-1);
Kontaktöffnungen durch die erste Passivierungsschicht für Source-Kontakte (122) und Drain-Kontakte (124);
ohmsches Kontaktmetall innerhalb der Kontaktöffnungen, das strukturiert ist, um Source-Kontakte (122) und Drain-Kontakte (124) zu bilden;
eine zweite Passivierungsschicht (300-2);
eine Gate-Kontaktöffnung durch die erste (300-1) und zweite (300-2) Passivierungsschicht zu dem p-GaN-Gate-Bereich (116);
Gate-Metall innerhalb der Gate-Kontaktöffnung, das strukturiert ist, um einen Gate-Kontakt (126) zu bilden, wobei das Gate-Metall auch eine Gate-Metall-Feldplatte (128) in einem Bereich zwischen dem Gate-Kontakt (126) und dem Drain-Kontakt (124) bildet;
eine dritte dielektrische Schicht (300-3), die darauf gebildet ist und eine abgestufte Zusammensetzung aufweist, wobei ein Boden der dritten dielektrischen Schicht eine dichtere Zusammensetzung als eine obere Schicht der dritten dielektrischen Schicht aufweist;
Öffnungen (221), die durch die dritte dielektrische Schicht für einen Source-Kontakt, einen Drain-Kontakt und einen Gate-Kontakt geätzt sind, und eine weitere Öffnung mit abgeschrägten Seitenwänden (227), die durch die dritte dielektrische Schicht (300-3) geätzt sind und durch die Gate-Metall-Feldplatte (128) geätzt sind;
mindestens eine Schicht aus leitfähigem Metall, die jede der Öffnungen füllt, um den Source-Kontakt (222), den Drain-Kontakt (224), den Gate-Kontakt (226) und eine abgeschrägte Gate-Feldplatte (228) zu bilden, wobei das leitfähige Metall die Öffnung mit den abgeschrägten Seitenwänden (227) füllt, um die abgeschrägte Gate-Feldplatte (228) in Kontakt mit der Gate-Metall-Feldplatte (128) zu bilden.

2. Halbleiterbauelementstruktur (10) nach Anspruch 1, wobei die mindestens eine Schicht aus leitfähigem Metall eine einzelne Metallschicht umfasst.

3. Halbleiterbauelementstruktur (10) nach einem von Anspruch 1, wobei die mindestens eine Schicht aus leitfähigem Metall eine Vielzahl von Metallschichten umfasst.

4. Halbleiterbauelementstruktur (10) nach einem der Ansprüche 1 bis 3, umfassend eine Verbindungsbahn (530), die den Source-Kontakt (222) und die abgeschrägte Gate-Feldplatte (228) verbindet.

5. Halbleiterbauelementstruktur (10) nach einem der Ansprüche 1 bis 4, wobei die dritte dielektrische Schicht (300-3) Vielzahl von dielektrischen Schichten umfasst, die nacheinander abgeschieden sind, um die abgestufte Zusammensetzung bereitzustellen.

6. Verfahren zum Herstellen eines Anreicherungsmodus-GaN-Halbleiter-Leistungstransistors (10), umfassend:
Bereitstellen einer Epitaxieschichtstruktur (112), umfassend ein Halbleitersubstrat (102), eine Pufferschicht (104), eine GaN-Halbleiter-Heterostruktur, umfassend eine GaN-Kanalschicht (106) und eine AlGaN-Sperrschicht (108), die einen aktiven 2DEG-Bereich (110) bereitstellt, und eine Blanket-p-GaN-Schicht;
Ätzen der Blanket-p-GaN-Schicht, um p-GaN-Gate-Bereiche (116) zu definieren;
Bereitstellen einer ersten Passivierungsschicht (300-1), die die p-GaN-Gate-Bereiche (106) bedeckt;
Ätzen von Kontaktöffnungen durch die erste Passivierungsschicht für einen Source-Kontakt (122) und einen Drain-Kontakt (124);
Abscheiden und Strukturieren von ohmschem Kontaktmetall, um den Source-Kontakt (122) und den Drain-Kontakt (124) zu bilden;
Bereitstellen einer zweiten Passivierungsschicht (300-2);
Ätzen von Gate-Kontaktöffnungen durch die erste (300-1) und zweite (300-2) Passivierungsschicht zu den p-GaN-Gate-Bereichen (116);
Abscheiden und Strukturieren von Gate-Metall, um einen Gate-Kontakt (126) und eine Gate-Metall-Feldplatte (128) zu bilden;
Abscheiden einer dritten dielektrischen Schicht (300-3) insgesamt, wobei die dritte dielektrische Schicht eine abgestufte Zusammensetzung aufweist, wobei ein Boden der dritten dielektrischen Schicht (300-3) eine dichtere Zusammensetzung und eine langsamere Ätzrate als eine Oberseite der dritten dielektrischen Schicht (300-3) aufweist;
Durchführen eines ersten Ätzprozesses der dritten dielektrischen Schicht (300-3), um Kontaktöffnungen (221) für einen Source-Kontakt, einen Gate-Kontakt und einen Drain-Kontakt zu bilden;
Durchführen eines zweiten Ätzprozesses der dritten dielektrischen Schicht (300-3), umfassend ein Nassätzen, um eine abgeschrägte Öffnung zu bilden, die sich nach unten zu der Gate-Metall-Feldplatte (128) erstreckt;
Abscheiden mindestens einer Schicht aus leitfähigem Metall, um die Kontaktöffnungen für den Source-Kontakt, Gate-Kontakt und Drain-Kontakt zu füllen und um eine abgeschrägte Gate-Feldplatte (228) innerhalb der abgeschrägten Öffnung zu bilden, sodass die abgeschrägte Gate-Feldplatte (228) Kontakt mit der Gate-Metall-Feldplatte (128) herstellt.

7. Verfahren nach Anspruch 6, wobei der Schritt des Abscheidens mindestens einer Schicht aus leitfähigem Metall eines von Abscheiden einer einzelnen Metallschicht oder Abscheiden einer Vielzahl von Metallschichten umfasst.

8. Verfahren nach Anspruch 6 oder 7, wobei das Abscheiden und Strukturieren von Gate-Metall, um den Gate-Kontakt (126) und die Gate-Metall-Feldplatte (128) zu bilden, einen Lift-Off-Metallprozess umfasst.

9. Verfahren nach einem der Ansprüche 6 bis 8, wobei das Abscheiden und Strukturieren von Gate-Metall, um den Gate-Kontakt (126) und die Gate-Metall-Feldplatte (128) zu bilden, Abscheiden und Ätzen des Gate-Metalls umfasst.

## Revendications

1. Une structure (10) de dispositif à semiconducteur comprenant un transistor de puissance à semiconducteur GaN en mode à enrichissement, comprenant :
une structure (112) de couche épitaxiale comprenant un substrat (102) à semiconducteur, une couche (104) tampon, une hétérostructure à semiconducteur GaN comprenant une couche (106) de canal en GaN et une couche (108) barrière en AlGaN donnant une région (110) active 2DEG ;
une couche en p-GaN structurée pour définir une région (116) de grille en p-GaN ;
une première couche (300-1) de passivation ;
des ouvertures de contact à travers la première couche de passivation pour des contacts (122) de source et des contacts (124) de drain ;
un métal ohmique de contact dans lesdites ouvertures de contact, qui est structuré pour former des contacts (122) de source et des contacts (124) de drain ;
une deuxième couche (300-2) de passivation ;
une ouverture de contact de grille allant à la région (116) de grille en p-GaN en passant à travers les première (300-1) et seconde (300-2) couches de passivation ;
un métal de grille, dans l'ouverture de contact de grille, structuré pour former un contact (126) de grille, le métal de grille formant aussi une plaque (128) de champ en métal de grille dans une région entre le contact (126) de grille et le contact (124) de drain ;
une troisième couche (300-3) diélectrique y étant formée en ayant une composition échelonnée, un fond de la troisième couche diélectrique ayant une composition plus dense qu'une couche de sommet de la troisième couche diélectrique ;
des ouvertures (221) ménagées par attaque chimique dans la troisième couche diélectrique pour un contact de source, un contact de drain et un contact de grille, et une autre ouverture ayant des parois (227) latérales inclinées ménagées par attaque chimique à travers la troisième couche (300-3) diélectrique et ménagées par attaque chimique à travers la plaque (128) de champ en métal de grille ;
au moins une couche de métal conducteur remplissant chacune desdites ouvertures, pour former le contact (222) de source, le contact (224) de drain, le contact (226) de grille et une plaque (228) de champ de grille inclinée, le métal conducteur remplissant les ouvertures ayant les parois (227) inclinées pour former la plaque (228) de champ de grille inclinée en contact avec la plaque (128) de champ en métal de grille.

2. La structure (10) de dispositif à semiconducteur de la revendication 1, dans laquelle la au moins une couche de métal conducteur comprend une seule couche métallique.

3. La structure (10) de dispositif à semiconducteur de l'une quelconque des revendications 1, dans laquelle la au moins une couche de métal conducteur comprend une pluralité de couches métalliques.

4. La structure (10) de dispositif à semiconducteur de l'une quelconque des revendications 1 à 3, comprenant une piste (530) d'interconnexion connectant le contact (222) de source et la plaque (228) de champ de grille inclinée.

5. La structure (10) de dispositif à semiconducteur de l'une quelconque des revendications 1 à 4, dans laquelle la troisième couche (300-3) diélectrique comprend une pluralité de couches diélectriques déposées séquentiellement pour obtenir ladite composition échelonnée.

6. Un procédé de fabrication d'un transistor (10) de puissance à semiconducteur GaN en mode à enrichissement comprenant :
se procurer une structure (112) de couche épitaxiale comprenant un substrat (102) à semiconducteur, une couche (104) tampon, une hétérostructure à semiconducteur GaN comprenant une couche (106) de canal en GaN et une couche (108) de barrière en AlGaN donnant une région (110) active 2DEG, et une couche de couverture en p-GaN ;
attaquer chimiquement la couche de couverture en p-GaN pour définir des régions (116) de grille en p-GaN ;
se procurer une première couche (300-1) de passivation recouvrant les régions (106) de grille en p-GaN ;
ménager par attaque chimique des ouvertures de contact dans la première couche de passivation pour un contact (122) de source et un contact (124) de drain ;
déposer et structurer du métal ohmique de contact pour former le contact (122) de source et le contact (124) de drain ;
se procurer une deuxième couche (300-2) de passivation ;
ménager par attaque chimique des ouvertures de contact de grille jusqu'aux régions (116) de grille en p-GaN à travers la première (300-1) et la deuxième (300-2) couches de passivation ;
déposer et structurer du métal de grille pour former un contact (126) de grille et une plaque (128) de champ en métal de grille ;
déposer une troisième couche (300-3) diélectrique sur le tout, la troisième couche diélectrique ayant une composition échelonnée, un fond de la troisième couche (300-3) diélectrique ayant une composition plus dense et une vitesse d'attaque chimique plus lente qu'un sommet de la troisième couche (300-3) diélectrique ;
effectuer une première opération d'attaque chimique de la troisième couche (300-3) diélectrique pour former des ouvertures (221) de contact pour un contact de source, un contact de grille, un contact de drain ;
effectuer une deuxième opération d'attaque chimique de la troisième couche (300-3) diélectrique comprenant une attaque chimique en voie humide pour former une ouverture inclinée, qui s'étend vers le bas jusqu'à la plaque (128) de champ en métal de grille ;
déposer au moins une couche de métal conducteur pour remplir les ouvertures de contact pour le contact de source, le contact de grille et le contact de drain et pour former une plaque (228) de champ de grille inclinée dans l'ouverture inclinée, de manière à ce que la plaque (228) de champ de grille inclinée fasse contact avec la plaque (128) de champ en métal de grille.

7. Le procédé de la revendication 6, dans lequel le stade de dépôt d'au moins une couche de métal conducteur comprend l'un de déposer une seule couche métallique ou de déposer une pluralité de couches métalliques.

8. Le procédé de la revendication 6 ou 7, dans lequel déposer et structurer du métal de grille pour former le contact (126) de grille et la plaque (128) de champ en métal de grille, comprend une opération d'arrachement de métal.

9. Le procédé de l'une quelconque des revendications 6 à 8, dans lequel déposer et structurer du métal de grille pour former le contact (126) de grille et la plaque (128) de champ en métal de grille comprend déposer et attaquer le métal de grille.
